# EUROPÄISCHE PATENTSCHRIFT

(11) **EP 2 845 268 B1**
(45) Veröffentlichungstag und Bekanntmachung des Hinweises auf die Patenterteilung: **10.08.2016**
(21) Anmeldenummer: 13719229.0
(22) Anmeldetag: 30.04.2013
(51) Int. Cl.: H01R 4/24, H01R 9/24, H01R 13/52, H01R 13/50

(54) **KABELCLIP FÜR MODULELEKTRONIK**
CABLE CLIP FOR MODULE ELECTRONICS
CLIP DE FIXATION DE CÂBLE POUR L'ÉLECTRONIQUE DES MODULES

(30) Priorität: 30.04.2012 DE 102012103789; 12.09.2012 DE 202012103480 U
(43) Veröffentlichungstag der Anmeldung: 11.03.2015
(73) Patentinhaber: SMA Solar Technology AG, 34266 Niestetal (DE)
(72) Erfinder: HOPF, Markus, 34314 Espenau (DE)
(74) Vertreter: REHBERG HÜPPE + PARTNER
(86) Internationale Anmeldenummer: PCT/EP2013/058963
(87) Internationale Veröffentlichungsnummer: WO 2013/164330

(56) Entgegenhaltungen:
- EP-A2- 2 395 604
- WO-A1-00/30216
- DE-A1- 19 741 603
- FR-A1- 2 854 282
- FR-A1- 2 895 575
- US-A- 5 513 075
- US-A- 5 714 717

## Beschreibung

### TECHNISCHES GEBIET DER ERFINDUNG

Die Erfindung bezieht sich auf eine Vorrichtung mit einem mehrteiligen Gehäuse, einer elektronischen Schaltung in dem Gehäuse und Anschlusseinrichtungen zum Anschluss der elektronischen Schaltung an zwei einen Leistungsstrom von einem Solarmodul führende, mit Isolierungen versehene Leitungen, so dass zumindest eine Komponente der elektrischen Schaltung dem Solarmodul parallel geschaltet ist.

Die elektrische Schaltung der Vorrichtung kann unterschiedliche Funktionen haben. Eine dieser möglichen Funktionen ist es, das jeweilige Solarmodul kurzzuschließen, um das Auftreten von die Integrität des Solarmoduls gefährdenden Überspannungen zu vermeiden oder um das mit der Ausgangsspannung des Solarmoduls verbundene Risiko eines elektrischen Schlags zu beseitigen.

### STAND DER TECHNIK

Solange Licht auf ein Solarmodul fällt, erzeugt dieses eine Ausgangsspannung, die bei aktuellen Solarmodulen im Leerlauffall mehr als 1000 V DC gegenüber Potentialerde betragen kann. Im Schadensfall, beispielsweise bei einem Brand, aber auch bei Installations- und Wartungsarbeiten, besteht daher die Gefahr eines gefährlichen elektrischen Schlags. Um dieser Gefahr entgegen zu wirken, ist es bekannt, ein Solarmodul mit einer elektrischen Schaltung zu versehen, die es im Bedarfsfall kurzschließt.

Die Implementierung einer solchen elektrischen Schaltung bei unterschiedlichen Solarmodulen ist jedoch nicht trivial. Solarmodule weisen unterschiedliche Anschlussdosen und unterschiedliche Stecker an den Anschlussdosen oder an aus diesen herausführenden, den Leistungsstrom von dem Solarmodul führenden Leitungen auf. Es gibt auch keinen Standard bezüglich der Ansteuerung einer solchen elektrischen Schaltung. Dies alles erschwert insbesondere das Nachrüsten eines vorhandenen Solarmoduls mit einer solchen elektrischen Schaltung.

Aus der WO 2012/012137 A1 ist eine feuchtigkeitsresistente Anschlussdose für ein Solarmodul bekannt, die für jede von zwei mit Isolierungen versehenen Leitungen einen Kanal in das Innere der Anschlussdose und einen dazu unter 90° verlaufenden weiteren Anbindungspunkt für die jeweilige Leitung aufweist. Im Bereich des Kanals ist das Gehäuse mehrteilig und wird durch Zusammenfügen seiner Teile auf die jeweilige Leitung dichtend aufgeklemmt. Der weitere Anbindungspunkt dient als Zugentlastung für die jeweilige in den Kanal eingeführte Leitung.

Aus der DE 10 2009 024 516 A1 ist eine elektrische Anschlussdose für den elektrischen Anschluss eines Solarmoduls bekannt. Die Anschlussdose weist ein Gehäuse, zwei eingangsseitige Anschlusselemente zur Kontaktierung zweier vom Solarmodul kommende Leitungen und zwei ausgangsseitige Anschlusselemente zum Anschluss externer Leitungen auf, wobei jeweils ein eingangsseitiges Anschlusselement innerhalb des Gehäuses elektrisch leitend mit jeweils einem ausgangsseitigen Anschlusselement verbunden ist. Die Anschlussdose soll die Gefahr eines Personenschadens durch elektrischen Schlag im Schadensfall minimieren, indem innerhalb des Gehäuses eine Sicherheitseinrichtung vorgesehen ist. Mit Bauelementen der Sicherheitseinrichtung ist hierbei eine elektrisch leitende Querverbindung zwischen den eingangsseitigen Anschlusselementen herstellbar, so dass in einem aktiven Zustand der Sicherheitseinrichtung die zwischen den eingangsseitigen Anschlusselementen anliegende Ausgangsspannung des Solarzellmoduls durch die Querverbindung reduziert ist.

Schneidklemmen sind bekannte elektrische Anschlusseinrichtungen, die die Isolierung einer Leitung durchtrennen und dann eine elektrische Verbindung zu der Leitung herstellen. Gemäß der EP1478053 B1 können im Niederspannungsbereich, beispielsweise in Bordnetzen von Fahrzeugen, mit Schneidklemmen auch nachträglich Steckverbinder an bestehenden Leitungen angebracht werden. In der EP 2 355 268 A1 werden solche im Englischen als "Insulation-displacement connectors" bezeichnete Schneidklemmen zum elektrischen Anschluss von einzelnen parallel geschalteten Solarmodulen über ihren Leistungsstrom führende Stichleitungen an zwei Busleitungen offenbart.

Eine Vorrichtung mit den Merkmalen des Oberbegriffs des unabhängigen Patentanspruchs 1 geht aus der FR 2 895 575 A1 hervor. Mit dieser Vorrichtung können beispielsweise Dioden zwischen zwei durchlaufende Leitungen geschaltet werden. Dabei werden die mit ihren Isolierungen durchlaufenden Leitungen automatisch kontaktiert, ohne durchtrennt zu werden.

Aus der WO 00/30216 A1 ist eine Vorrichtung mit einem mehrteiligen Gehäuse, einer in dem Gehäuse zwischen zwei Anschlussleitungen eines Solarpaneels geschalteten Diode und Anschlusseinrichtungen für zwei mit Isolierungen versehene Leitungsenden bekannt. Dabei sind Teile der Anschlusseinrichtungen um die Leitungsenden herum verrastbar, wobei Schneidklemmen der Anschlusseinrichtungen die Isolierungen durchdringen und die Leitungsenden elektrisch kontaktieren. Die Leitungsenden werden so an die Anschlussleitungen des Solarpaneels und die dazwischengeschaltete Diode angeschlossen.

Aus der FR 2 854 282 A1 ist ein Stecker zum Anschluss von Solarmodulen bekannt, der entweder an mehrere parallel durchlaufende Leitungen oder an Enden dieser Leitungen angeschlossen werden kann. Dabei erfolgt der Anschluss mit Hilfe von Schneidklemmen, die eine Isolierung der Leitungen durchdringen, wenn die Leitungen zwischen einem Grundkörper des Steckers und einem hinteren Abschlusskörper des Steckers eingeklemmt werden.

### AUFGABE DER ERFINDUNG

Der Erfindung liegt die Aufgabe zugrunde, eine Vorrichtung mit den Merkmalen des Oberbegriffs des unabhängigen Patentanspruchs 1 aufzuzeigen, mit der beispielsweise Sicherheits-und Schutzeinrichtungen sowie Diagnoseeinrichtungen mit Schaltungen, bei denen nicht nur Komponenten zwischen zwei Leitungen, sondern auch in mindestens eine der beiden Leitungen geschaltet werden, bei Solarmodulen ohne großen Aufwand implementiert, insbesondere auch nachgerüstet, werden können.

### LÖSUNG

Die Aufgabe der Erfindung wird durch eine Vorrichtung mit den Merkmalen des unabhängigen Patentanspruchs 1 gelöst. Bevorzugte Ausführungsformen der Vorrichtung sind in den abhängigen Patentansprüchen 2 bis 14 definiert. Der Patentanspruch 15 ist auf ein Solarmodul mit einer erfindungsgemäßen Vorrichtung gerichtet.

### BESCHREIBUNG DER ERFINDUNG

Die Erfindung betrifft eine Vorrichtung mit einem mehrteiligen Gehäuse, einer elektrischen Schaltung in dem Gehäuse und Anschlusseinrichtungen zum Anschluss der elektrischen Schaltung an zwei ein Leistungsstrom von einem Solarmodul führende, mit Isolierungen versehene Leitungen, so dass zumindest eine Komponente der elektrischen Schaltung dem Solarmodul parallel geschaltet ist. Dabei sind die Teile des Gehäuses um die mit ihren Isolierungen durchlaufenden Leitungen zusammenfügbar, und die Anschlusseinrichtungen weisen Penetrationselemente auf, die beim Zusammenfügen der Teile des Gehäuses die Isolierungen durchdringen und die Leitungen elektrisch kontaktieren.

Die Vorrichtung kann so sehr schnell und einfach an einem Solarmodul bzw. den von diesem abgehenden Leitungen installiert werden. Damit ist auch eine Nachrüstung völlig problemlos. Insbesondere besteht für das Vorsehen der elektrischen Schaltung keine Abhängigkeit von den Solarmodulen bestimmter Anbieter. Vielmehr kann beispielsweise der Hersteller einer Sicherheitsanlage die elektrische Schaltung nach seinen Bedürfnissen optimieren und in dieser Form problemlos an beliebigen Solarmodulen installieren. Auch wenn diese Installation nicht in der Anschlussdose des jeweiligen Solarmoduls erfolgt, kann sie mit der hier offenbarten Vorrichtung doch sehr nahe an den Solarzellen vorgenommen werden. Im Vergleich zu herkömmlichen Einrichtungen mit Schneidklemmen sind die Penetrationselemente bei der hier offenbarten Vorrichtung so angeordnet, dass sie durch das Zusammenfügen der Teile des Gehäuses aktiviert werden, ohne dass es zwingend spezieller Auf- oder Anlegewerkzeuge bedarf. Dies schließt jedoch nicht aus, dass das Gehäuse der Vorrichtung mithilfe eines Werkzeugs zusammengefügt wird, um bei Bedarf erhöhte Fügekräfte bereitzustellen.

Die Vorrichtung ist für solche Schaltungen geeignet, bei denen nicht nur Komponenten zwischen die beiden Leitungen geschaltet werden, sondern auch in mindestens eine der beiden Leitungen. Dazu ist für diese mindestens eine Leitung eine Schneidklinge aus elektrisch isolierendem Material vorgesehen, die die Leitung beim Zusammenfügen des Gehäuses durchtrennt. Dann sind auf beiden Seiten der Schneidklinge Penetrationselemente angeordnet, um die elektrische Schaltung an beide nach dem Durchtrennen freien Enden der Leitung anzuschließen. Die Schneidklinge selbst kann z. B. aus Keramik oder hartem Kunststoff ausgebildet sein.

Vorzugsweise verrasten die zusammengefügten Teile des Gehäuses der Vorrichtung aneinander und konservieren so ihre zusammengefügte Stellung.

Im einfachsten Fall ist das Gehäuse zweiteilig, d. h. es müssen nur zwei Teile um die Leitungen zusammengefügt werden.

In jedem Fall können die Teile des Gehäuses über Gelenke, insbesondere Festkörpergelenke, oder sogenannte Filmscharniere miteinander verbunden sein, was die Handhabung der Teile des Gehäuses vor ihrem Zusammenfügen sehr einfach macht.

Die Penetrationselemente können als Schneidklemmen ausgebildet sein. Diese trennen beim Zusammenfügen des Gehäuses die Isolierungen der Leitungen auf und stellen durch ein ausreichendes Einschneiden in den Leitungsquerschnitt eine elektrische Kontaktierung mit ausreichender Stromtragfähigkeit sicher. Auch möglich und bei Ausführung der Leitungen als mehradrige Litzen vorteilhaft ist eine Ausgestaltung der Penetrationselemente als Nadeln. Diese sind so ausgerichtet, dass sie beim Zusammenfügen des Gehäuses durch die Isolierung hindurch stechen und zwischen die Adern der Leitungen dringen. Auf diese Weise wird eine Reduktion des Leitungsquerschnitts der Leitungen vermieden.

Vorzugsweise sind die Anschlusseinrichtungen der Vorrichtung auf gegenüberliegenden Seiten ihrer elektrischen Schaltung vorgesehen, so dass die beiden Leitungen in gewissem Abstand zueinander durch das zusammengefügte Gehäuse hindurch verlaufen. Hierdurch werden Kurzschlussgefahren durch einen geringen Abstand der lokal abisolierten Leitungen vermieden; und die elektrische Schaltung ist räumlich dort zwischen den Leitungen angeordnet, wo sie elektrisch wirksam werden soll.

Die elektrischen Leitungen, die den Leistungsstrom von einem Solarmodul abführen, verlaufen häufig durchs Freie, d. h. sie sind allen denkbaren Umwelteinflüssen ausgesetzt. Damit dies zu keinen Störungen der Anschlusseinrichtungen und der elektrischen Schaltung auch über sehr lange Zeiträume hinweg führt, sind vorzugsweise Dichtungen vorgesehen, die das zusammengefügte Gehäuse der Vorrichtung um die Leitungen herum abdichten, so dass insbesondere keine Feuchtigkeit in das Gehäuse eindringen kann.

Die Dichtungen können speziell dafür vorgesehen sein, um die Anschlusseinrichtungen umfassende Bereiche des zusammengefügten Gehäuses abzudichten. Die elektrische Schaltung kann ihrerseits separat abgedichtet sein, indem sie z. B. in einem separaten abgedichteten Bereich des zusammengefügten Gehäuses angeordnet oder auch vergossen ist.

Zur Ausbildung der Dichtungen kann eine reaktive Dichtmasse in einem zu öffnenden Reservoir in dem Gehäuse angeordnet sein. Dieses Reservoir kann manuell vor dem Zusammenfügen des Gehäuses geöffnet werden, indem beispielsweise eine Abdeckung entfernt oder durchbrochen wird, oder aber Teile des Gehäuses können so ausgebildet sein, dass bei einem Zusammenfügen der Teile das Reservoir automatisch geöffnet und die Dichtmasse aus dem Reservoir herausgedrückt und so an die Stellen gebracht wird, wo eine nicht nur kraftschlüssig, sondern auch stoffschlüssig anbindende Dichtung erwünscht ist. Ebenso ist es möglich, dass die Dichtmasse erst nach dem Zusammenfügen des Gehäuses durch eine Öffnung injiziert wird, um es in die Bereiche der gewünschten Dichtungen einzubringen.

Ein Material der Dichtmasse wird vorzugsweise so ausgewählt, dass es eine zuverlässige und dauerhafte Anbindung, beispielsweise durch Vulkanisation, mit dem Gehäuse und/oder der Isolation der elektrischen Leitung eingeht:

Konkret kann die elektrische Schaltung der Vorrichtung eine Schutz- oder Sicherheitsschaltung für das Solarmodul aufweisen, um beispielsweise einen Schutz vor Überspannungen bereitzustellen oder um das Solarmodul im Bedarfsfall kurzzuschließen. Zu letzterem Zweck kann die elektrische Schaltung einen mittels eines externen Signals schließbaren Kurzschlusspfad zwischen den Anschlusseinrichtungen aufweisen. Zum Empfang dieses externen Signals kann die Vorrichtung zusätzlich eine Signalleitung aufweisen oder an eine Signalleitung angeschlossen werden. Die Signalleitung kann als Direktleitung zum Empfänger oder als Rundleitung über eine Mehrzahl von erfindungsgemäßen Vorrichtungen realisiert sein. Alternativ kann das Signal aber auch kabellos, beispielsweise per Funk, oder als auf die Leitungen aufmoduliertes elektrisches Signal übertragen werden.

In einer weiteren Ausgestaltung kann die elektrische Schaltung alternativ oder zusätzlich eine Diagnoseeinrichtung für das Solarmodul aufweisen, um Daten über einen aktuellen Zustand des Solarmoduls an einen externen Empfänger zu übermitteln. Auch diese Übermittlung kann mittels einer Signalleitung oder kabellos erfolgen.

Normalerweise kommt die Vorrichtung ohne eine Zugentlastungseinrichtung aus, da die Leitungen durch die Vorrichtung hindurch verlaufen, und so Zugkräfte selbst übertragen bzw. abstützen. Wenn jedoch eine Leitung beim Zusammenfügen des Gehäuses der Vorrichtung durchtrennt wird, kann eine solche Zugentlastungseinrichtung sinnvoll sein. Sie kann auch allein deshalb vorgesehen werden, um ein Verrutschen des Gehäuses der Vorrichtung auf den Leitungen bzw. eine Querbelastung ihrer Schneidklemmen zu verhindern. Bevorzugt ist es, solche Zugentlastungseinrichtungen vorzusehen, die die jeweilige Leitung in eine Mäanderform zwingen. Die jeweilige Zugentlastungseinrichtung kann auch einen Knickschutz für die einlaufende Leitung bereitstellen.

In einer Ausgestaltung der Erfindung sind zur elektrischen Verbindung der elektrischen Schaltung für mindestens eine der Leitungen mindestens zwei Penetrationselemente vorgesehen. Dies kann die Qualität der elektrischen Kontaktierung verbessern, aber auch dazu dienen, dass durch den Kontakt eines ersten Penetrationselementes ein Stromfluss zwischen der Leitung und der elektrischen Schaltung bewirkt wird, während über den elektrischen Kontakt des zweiten Penetrationselementes eine Spannung abgegriffen wird. Auf diese Weise kann der Einfluss eines durch den fließenden Strom hervorgerufenen Spannungsabfalls am Kontakt des ersten Penetrationselementes auf die abgegriffene Spannung vermieden werden. Die mindestens zwei Penetrationselemente können an unterschiedlichen Positionen entlang der Verlaufsrichtung oder direkt nebeneinander in einer Querschnittsebene der Leitung angeordnet sein.

In einer weiterführenden Ausgestaltung können mehrere Nadeln als Penetrationselemente derart versetzt angeordnet sein, so dass beim Eindringen der Nadeln in das Kabel ein erhöhter Anpressdruck zwischen Litze und Nadeln erzeugt wird. Dieser Effekt wird durch eine leicht konische Form der Nadeln unterstützt, wodurch der Durchmesser der eindringenden Nadel mit zunehmender Eindringtiefe steigt.

Vorteilhafte Weiterbildungen der Erfindung ergeben sich aus den Patentansprüchen, der Beschreibung und den Zeichnungen. Die in der gesamten Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Die in der gesamten Beschreibung offenbarten Ausführungsbeispiele sollen dem Fachmann lediglich Möglichkeiten der Ausführung der Erfindung aufzeigen, die Erfindung jedoch nicht auf diese Ausführungsbeispiele beschränken. Im Gegenteil soll der Fachmann diese Ausführungsbeispiele als Anregungen ansehen, um die Ausführung der Erfindung - auch mit hier nicht konkret offenbarten Varianten der Ausführung ihrer Merkmale - an den konkreten Bedarf des Einzelfalls anzupassen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Element die Rede ist, ist dies so zu verstehen, dass genau ein Element, zwei Elemente oder mehr Elemente vorhanden sind. Wenn hingegen nur die genaue Anzahl eines Merkmals angegeben werden soll, findet das Adjektiv "genau" vor dem jeweiligen Merkmal Verwendung. Diese Merkmale können durch andere Merkmale ergänzt werden oder die einzigen Merkmale sein, aus denen das jeweilige Erzeugnis besteht.

### KURZBESCHREIBUNG DER FIGUREN

Die Erfindung wird im Folgenden anhand von Ausführungsbeispielen unter Bezugnahme auf die beigefügten Zeichnungen näher erläutert und beschrieben.
- **Fig. 1**: zeigt die Rückseite eines Solarmoduls mit einer Vorrichtung, die an zwei einen Leistungsstrom von dem Solarmodul führende Leitungen angeschlossen ist.
- **Fig. 2**: zeigt den Innenaufbau der Vorrichtung gemäß Fig. 1 in einer ersten Ausführungsform, die nicht unter die anhängenden Patentansprüche fällt.
- **Fig. 3**: zeigt den Innenaufbau der Vorrichtung gemäß Fig. 1 in einer zweiten Ausführungsform, die unter die anhängenden Patentansprüche fällt.
- **Fig. 4**: zeigt die Ausführungsform der Vorrichtung gemäß Fig. 3 mit zusätzlichen Zugentlastungseinrichtungen.
- **Fig. 5**: ist eine Ansicht einer separaten, noch nicht an Leitungen installierten Vorrichtung mit noch geöffnetem Gehäuse.
- **Fig. 6**: zeigt den Innenaufbau der Vorrichtung gemäß Fig. 1 in einer dritten Ausführungsform, die nicht unter die anhängenden Patentansprüche fällt.
- **Fig. 7**: ist eine Ansicht einer separaten, noch nicht an Leitungen installierten Vorrichtung mit noch geöffnetem Gehäuse gemäß der dritten Ausführungsform.

### FIGURENBESCHREIBUNG

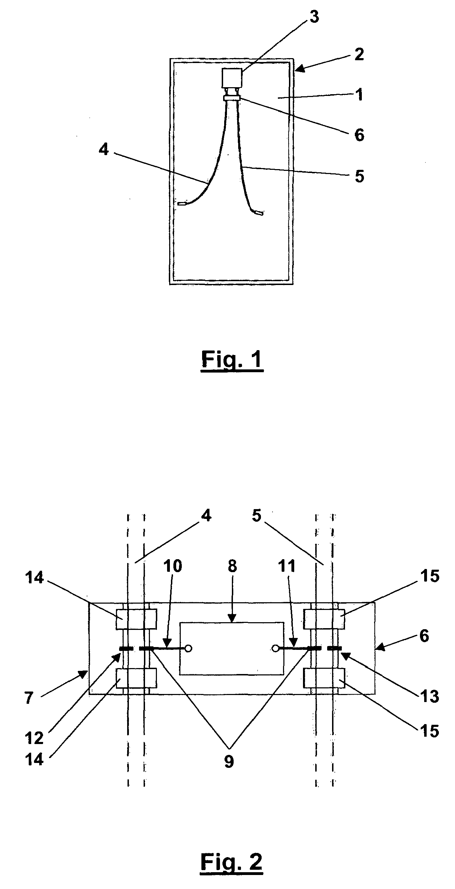

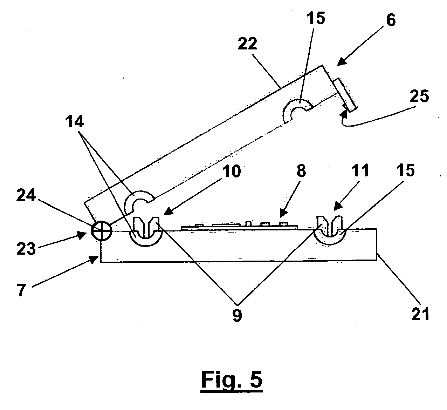

**Fig. 1** zeigt die Rückseite 1 eines Solarmoduls 2. An der Rückseite 1 ist eine Anschlussdose 3 gelagert, aus der zwei mit Isolierungen versehene Leitungen 4 und 5 herausführen. Die Leitungen 4 und 5 führen den von dem Solarmodul 2 generierten Leistungsstrom. An den Leitungen 4 und 5 ist außerhalb der Anschlussdose 3 eine Vorrichtung 6 installiert, wie sie jetzt unter Bezugnahme auf die weiteren Figuren näher erläutert werden wird.
**Fig. 2** zeigt eine Ausführungsform der Vorrichtung 6, die nicht unter die anhängenden Patentansprüche fällt. In einem Gehäuse 7 ist eine elektrische Schaltung 8 vorgesehen, die an beide Leitungen 4 und 5 angeschlossen ist. Dazu weist die Vorrichtung 6 in dem Gehäuse 7 Schneidklemmen 9 als Penetrationselemente auf, die die Isolierung der jeweiligen Leitung 4 und 5 durchtrennen und die Leitung selbst elektrisch kontaktieren. Die Schneidklemmen 9 sind Bestandteil von Anschlusseinrichtungen 10 und 11 der Vorrichtung 6, die die Leitungen 4 und 5 mit der elektrischen Schaltung 8 verbinden. Bereiche 12 und 13 des Gehäuses 7, sind durch Dichtungen 14 und 15 abgedichtet, die - gegebenenfalls in Verbindung mit einer (nicht gezeigten) Gehäusedichtung - insbesondere ein Eintreten von Feuchtigkeit in das Gehäuse 6 bis in die Bereiche 12 und 13 verhindern. Auf diese Weise wird erreicht, dass die Leitungen 4 und 5 ihre elektrische Isolationswirkung auch beispielsweise gegenüber Feuchtigkeit nicht einbüßen, obwohl ihre Isolierungen in den Bereichen 12 und 13 des Gehäuses 7 von den Schneidklemmen 9 durchdrungen sind.

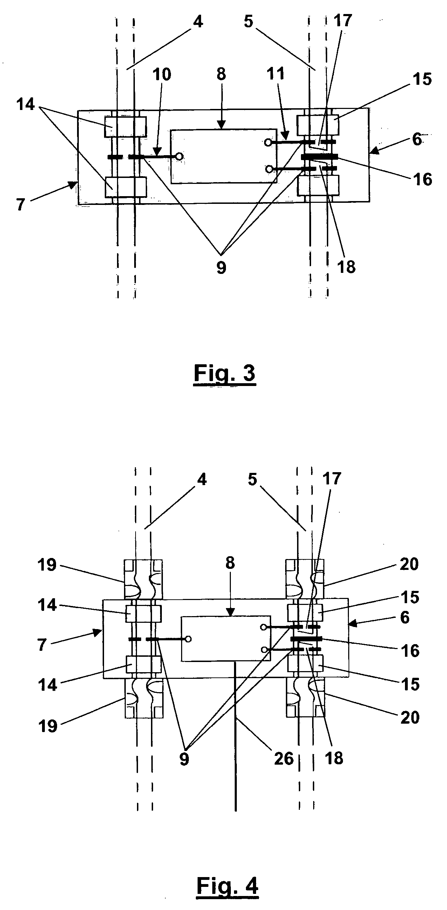

**Fig. 3** zeigt eine unter die anhängenden Patentansprüche fallende Ausführungsform der Vorrichtung 6, bei der die elektrische Schaltung 8 nicht nur zwischen die Leitungen 4 und 5 geschaltete Komponenten, sondern auch mindestens eine in die Leitung 5 geschaltete Komponente aufweist. Dazu weist die Vorrichtung 6 eine Schneidklinge 16 aus elektrisch isolierendem Material auf, die beim Zusammenfügen des Gehäuses 7 die Leitung 5 durchtrennt hat und jetzt die freien Enden 17 und 18 der Leitung 5 elektrisch voneinander isoliert. Auf beiden Seiten der Schneidklinge 16, die z. B. aus Keramik oder hartem Kunststoff ausgebildet sein kann, sind Schneidklemmen 9 zur Kontaktierung der freien Enden 17 und 18 der Leitung 5 vorgesehen.
**Fig. 4** zeigt, dass die unter die anhängenden Patentansprüche fallende Vorrichtung 6 auch mit Zugentlastungseinrichtungen 19 und 20 für die beiden Leitungen 4 und 5 ausgestattet werden kann, um insbesondere bei der Leitung 5 ein Herausziehen der freien Enden 17 und 18 aus der Vorrichtung 6 zu vermeiden. Durch die Zugentlastungseinrichtungen 19 und 20 hindurch verlaufen die Leitungen 4 und 5 mäanderförmig, und die Zugentlastungseinrichtungen stellen zugleich einen Knickschutz für die in die Vorrichtung 6 einlaufenden bzw. aus ihr herauslaufenden Leitungen und 5 bereit. Zudem ist in Fig. 4 eine an die elektrische Schaltung 8 angeschlossene und aus dem Gehäuse 7 heraus führende Signalleitung 26 gezeigt, über die die elektrische Schaltung 8 Signale empfangen und/oder senden kann. Es versteht sich, dass gegebenenfalls auch die Durchführung der Signalleitung 26 durch das Gehäuse 7 abgedichtet ist. Zudem kann in der Signalleitung 26 eine Steckverbindung angeordnet sein. Konkret kann ein erster Abschnitt der Signalleitung 26 in einem Stecker an dem Gehäuse 7 enden. Die Signalleitung 26 kann ein- oder mehradrig sein. Eine Signalübermittlung zu und von der elektrischen Schaltung 8 kann auch drahtlos oder mittels Power Line-Kommunikation über die Leitungen 4 und 5 erfolgen.
Die Seitenansicht gemäß **Fig. 5** zeigt eine Ausführungsform der Vorrichtung 6 mit einem zweiteiligen Gehäuse 7, die nicht unter die anhängenden Patentansprüche fällt. In dem unteren Teil 21 des Gehäuses 7 ist die elektrische Schaltung 8 und sind die Schneidklemmen 9 sowie je eine Hälfte der Dichtungen 14 und 15 vorgesehen. Der obere Teil 22 des Gehäuses 7 ist über ein Gelenk 23, dessen Achse 24 parallel zu den hier nicht dargestellten Leitungen 4 und 5 verläuft, an den Teil 21 angelenkt und weist eine Rastnase 25 zum Verrasten an dem Teil 21 in zusammengefügter, d. h. geschlossener Stellung des Gehäuses 7 auf. Beim Zusammenklappen der beiden Teile 21 und 22 um das Gelenk 23 wird zunächst die hier nicht dargestellte Leitung 4 in die ihr zugeordnete Schneidklemme 9 gedrückt und elektrisch kontaktiert. Danach wird dann mit der weiteren Schneidklemme 9 auch die Leitung 5 elektrisch kontaktiert. Beim weiteren Schließen des Gehäuses 7 dichten die Dichtungen 14 und 15 die Leitungen 4 und 5 ab und schützen damit auch die elektrische Schaltung 8 vor Feuchtigkeiten und anderen Umwelteinflüssen. Auch das Durchtrennen einer oder beider Leitungen mit einer oder ggf. zwei Schneidklingen 16 gemäß den Fig. 3 und 4 erfolgt beim Zusammenfügen des mehrteiligen Gehäuses 7.

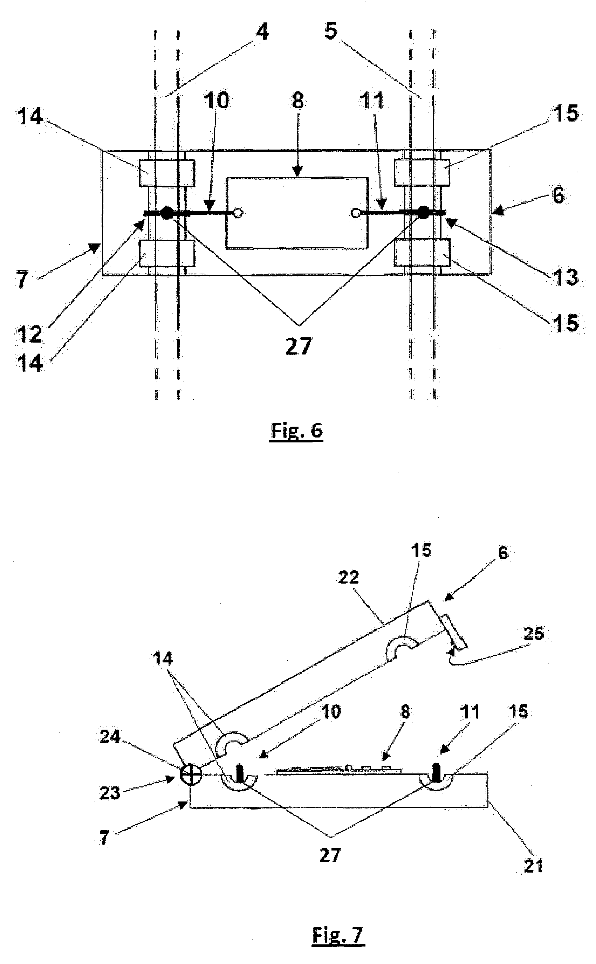

**Fig. 6** zeigt eine nicht unter die anhängenden Patentansprüche fallende Ausführungsform der Vorrichtung 6 mit Nadeln 27 als Penetrationselemente. Diese ersetzen hier die Schneidklemmen 9 aus Fig. 2 und sind in dieser Ansicht senkrecht zur Zeichenebene ausgerichtet. Vorzugsweise sind die Nadeln 27 mittig zum Verlauf der Leitungen 4, 5 angeordnet, um deren Isolierung zuverlässig zu durchdringen. Die Nadeln 27 können alternativ oder zusätzlich zu den Schneidklemmen 9 in allen vorgenannten Ausführungen der Erfindung eingesetzt werden, wobei Nadeln 27 und Schneidklemmen 9 getrennte oder in einstückiger Weise kombinierte Penetrationselemente bilden können. Die Nadeln 27 können im Gehäuse 7 so fixiert sein, dass die Kontaktierung vor oder beim Zusammenfügen der Gehäuseteile 21, 22 erfolgt. Alternativ kann das Gehäuse 7 Öffnungen aufweisen, durch die die Nadeln erst nach dem Zusammenfügen des Gehäuses 7, zum Beispiel durch Eindrücken oder Einschrauben, eingebracht werden und die Leitungen 4, 5 kontaktieren. Diese Abwandlung kann auch bei Schneidklemmen 9 umgesetzt werden.
Die Seitenansicht gemäß **Fig. 7** zeigt die nicht unter die anhängenden Patentansprüche fallende Ausführung der Vorrichtung 6 mit Nadeln 27 als Penetrationselemente. Beim Zusammenklappen der beiden Teile 21 und 22 um das Gelenk 23 wird zunächst die hier nicht dargestellte Leitung 4 in die ihr zugeordnete Nadel 27 gedrückt und elektrisch kontaktiert. Danach wird dann mit der weiteren Nadel 27 auch die Leitung 5 elektrisch kontaktiert. Beim weiteren Schließen des Gehäuses 7 dichten die Dichtungen 14 und 15 die Leitungen 4 und 5 ab und schützen damit auch die elektrische Schaltung 8 vor Feuchtigkeit und anderen Umwelteinflüssen. Auch das Durchtrennen einer oder beider Leitungen mit einer oder ggf. zwei Schneidklingen 16 gemäß den Fig. 3 und 4 kann bei dieser Ausführung realisiert werden und erfolgt beim Zusammenfügen des mehrteiligen Gehäuses 7.

Die elektrische Schaltung 8 kann insbesondere dazu vorgesehen sein, das jeweilige Solarmodul 2 bei Bedarf kurzzuschließen, um Gefährdungen durch die hohe Ausgangsspannung des Solarmoduls 2 durch Kurzschließen des Solarmoduls 2 zu beseitigen. Die Notwendigkeit hierfür steht beispielsweise im Brandfall oder bei Wartungsarbeiten am Tage. Alternativ oder zusätzlich kann die elektrische Schaltung 8 auch dazu eingerichtet sein, das Solarmodul 2 zu überwachen bzw. dessen Zustand zu diagnostizierten und das Ergebnis der Überwachung bzw. Diagnose über die Signalleitung 26 gemäß Fig. 4 oder kabellos an einen Empfänger zu übermitteln. Die Diagnose des überwachten Solarmoduls kann beispielsweise die Bestimmung mindestens eine der folgenden Kenngrößen umfassen: eine Generatorspannung des Solarmoduls, eine Temperatur des Solarmoduls, sowie das Vorhandensein eines Lichtbogens im Bereich der elektrischen Leitungen des Solarmoduls.

### BEZUGSZEICHENLISTE

- 1: Rückseite
- 2: Solarmodul
- 3: Anschlussdose
- 4: Leitung
- 5: Leitung
- 6: Vorrichtung
- 7: Gehäuse
- 8: elektrische Schaltung
- 9: Schneidklemme
- 10: Anschlusseinrichtung
- 11: Anschlusseinrichtung
- 12: Bereich
- 13: Bereich
- 14: Dichtung
- 15: Dichtung
- 16: Schneidklinge
- 17: freies Ende
- 18: freies Ende
- 19: Zugentlastungseinrichtung
- 20: Zugentlastungseinrichtung
- 21: Teil des Gehäuses
- 22: Teil des Gehäuses
- 23: Gelenk
- 24: Achse
- 25: Rastnase
- 26: Signalleitung
- 27: Nadel
- 9,27: Penetrationselemente

## Patentansprüche

1. Vorrichtung (6) mit
- einem mehrteiligen Gehäuse (7),
- einer elektrischen Schaltung (8) in dem Gehäuse (7) und
- Anschlusseinrichtungen (10, 11) zum Anschluss der elektrischen Schaltung (8) an zwei einen Leistungsstrom von einem Solarmodul (2) führende, mit Isolierungen versehene Leitungen (4, 5),
- so dass zumindest eine Komponente der elektrischen Schaltung (8) dem Solarmodul (2) parallel geschaltet ist,
- wobei die Teile (21, 22) des Gehäuses (7) um die mit ihren Isolierungen durchlaufenden Leitungen (4, 5) zusammenfügbar sind und
- wobei die Anschlusseinrichtungen (10, 11) Penetrationselemente (9, 27) aufweisen, die beim Zusammenfügen der Teile (21, 22) des Gehäuses (7) die Isolierungen durchdringen und die Leitungen (4, 5) elektrisch kontaktieren,
**dadurch gekennzeichnet,**
- **dass** für mindestens eine der Leitungen (4, 5) eine Schneidklinge (16) aus elektrisch isolierendem Material vorgesehen ist, die die Leitung (4, 5) beim Zusammenfügen des Gehäuses (7) durchtrennt, wobei auf beiden Seiten der Schneidklinge (16) Penetrationselemente (9, 27) angeordnet sind.

2. Vorrichtung (6) nach Anspruch 1, **dadurch gekennzeichnet, dass** die zusammengefügten Teile (21, 22) des Gehäuses (7) aneinander verrasten.

3. Vorrichtung (6) nach Anspruch 1 oder 2, **dadurch gekennzeichnet, dass** das Gehäuse (7) zweiteilig ist.

4. Vorrichtung (6) nach einem der vorhergehenden Ansprüche, **dadurch gekennzeichnet, dass** die Teile (21, 22) des Gehäuses (7) über ein Gelenk (23) oder Filmscharnier miteinander verbunden sind.

5. Vorrichtung (6) nach einem der vorhergehenden Ansprüche, **dadurch gekennzeichnet, dass** die Penetrationselemente (9, 27) Schneidklemmen (9) und/oder Nadeln (27) umfassen.

6. Vorrichtung (6) nach einem der vorhergehenden Ansprüche, **dadurch gekennzeichnet, dass** die Anschlusseinrichtungen (10, 11) auf gegenüberliegenden Seiten der elektrischen Schaltung (8) vorgesehen sind.

7. Vorrichtung (6) nach einem der vorhergehenden Ansprüche, **dadurch gekennzeichnet, dass** Dichtungen (14, 15) das zusammengefügte Gehäuse (7) um die Leitungen (4, 5) herum abdichten.

8. Vorrichtung (6) nach einem der vorhergehenden Ansprüche, **dadurch gekennzeichnet, dass** Dichtungen (14, 15) die Anschlusseinrichtungen (10, 11) umfassende Bereiche (12, 13) des zusammengefügten Gehäuses (7) abdichten.

9. Vorrichtung (6) nach Anspruch 7 oder 8, **dadurch gekennzeichnet, dass** eine reaktive Dichtmasse zur Ausbildung der Dichtungen (14, 15) in einem zu öffnenden Reservoir in dem Gehäuse (7) angeordnet ist, wobei die Teile des Gehäuses (7) optional so ausgebildet sind, dass beim Zusammenfügen der Teile (21, 22) das Reservoir geöffnet und die Dichtmasse aus dem Reservoir herausgedrückt wird.

10. Vorrichtung (6) nach einem der vorhergehenden Ansprüche, **dadurch gekennzeichnet, dass** die elektrische Schaltung (8) in einem abgedichteten Bereich des zusammengefügten Gehäuses (7) angeordnet ist.

11. Vorrichtung (6) nach einem der vorhergehenden Ansprüche, **dadurch gekennzeichnet, dass** die elektrische Schaltung (8) eine Schutz-, eine Sicherheits- und/oder eine Diagnoseschaltung für das Solarmodul (2) aufweist, wobei die elektrische Schaltung (8) optional einen mittels eines externen Signals schließbaren Kurzschlusspfad zwischen den Anschlusseinrichtungen (10, 11) aufweist.

12. Vorrichtung (6) nach einem der vorhergehenden Ansprüche, **dadurch gekennzeichnet, dass** die elektrische Schaltung (8) an eine aus dem Gehäuse (7) heraus führende Signalleitung (26) angeschlossen ist.

13. Vorrichtung (6) nach einem der vorhergehenden Ansprüche, **dadurch gekennzeichnet, dass** für mindestens eine der Leitungen (4, 5) mindestens eine Zugentlastungseinrichtung (19, 20) vorgesehen ist, die die Leitung (4, 5) in eine Mäanderform zwingt.

14. Vorrichtung (6) nach einem der vorhergehenden Ansprüche, **dadurch gekennzeichnet, dass** für mindestens eine der Leitungen (4, 5) mindestens zwei Penetrationselemente (9, 27) vorgesehen sind, die über getrennte Anschlusseinrichtungen (10, 11) mit der elektrischen Schaltung (8) verbunden sind.

15. Solarmodul (2) mit zwei einen Leistungsstrom von dem Solarmodul (2) führenden, Isolierungen aufweisenden Leitungen (4, 5) und mit einer an den Leitungen (4, 5) angebrachten Vorrichtung (6) nach einem der vorhergehenden Ansprüche.

## Claims

1. An apparatus (6) comprising:
- a multi-part housing (7),
- an electric circuitry (8) arranged within the housing (7),
- connection devices (10, 11) for connecting the electric circuitry (8) to two lines (4, 5) carrying a current of a solar module (2) and being provided with insulations,
- such that at least one component of the electric circuitry (8) is connected in parallel to the solar module (2),
- wherein parts (21, 22) of the housing (7) are capable to be assembled around the lines running with their insulations through the housing (7), and
- wherein the connection devices (10, 11) include insulation displacement terminals (9, 27) configured to displace the insulations and electrically contact the two lines (4, 5) while assembling the housing (7),
**characterised in that**
- for at least one of the lines (4, 5), a cutting blade (16) made of an electrically insulating material is provided, configured to cut through the at least one of the lines (4, 5) while assembling the housing (7), wherein on both sides of the cutting blade (16) insulation displacement terminals (9, 27) are arranged.

2. The apparatus (6) of claim 1, **characterised in that** assembled parts (21, 22) of the housing (7) are configured to snap into place with each other.

3. The apparatus (6) of claim 1 or 2, **characterised in that** the housing (7) is two-part.

4. The apparatus (6) of any of the preceding claims, **characterised in that** parts (21, 22) of the housing (7) are connected to each other via a joint (23) or film hinge.

5. The apparatus (6) of any of the preceding claims, **characterised in that** the insulation displacement terminals (9, 27) include cutting terminals (9) and/or piercing terminals (27).

6. The apparatus (6) of any of the preceding claims, **characterised in that** the connection devices (10, 11) are provided on opposite sides of the electric circuitry (8).

7. The apparatus (6) of any of the preceding claims, **characterised in that** gaskets (14, 15) seal the assembled housing (7) around the lines (4, 5).

8. The apparatus (6) of any of the preceding claims, **characterised in that** the gaskets (14, 15) seal sections (12, 13) of the assembled housing (7) enclosing the connection devices (10, 11).

9. The apparatus (6) of claims7 or 8, **characterised in that** a reactive sealing mass for forming the gaskets (14, 15) is arranged in a reservoir inside the housing (7), wherein parts of the housing (7) are configured to open the reservoir and to press the sealing mass out of the reservoir when assembling the housing parts.

10. The apparatus (6) of any of the preceding claims, **characterised in that** the electric circuitry (8) is arranged in a sealed section of the housing (7).

11. The apparatus (6) of any of the preceding claims, **characterised in that** the electric circuitry (8) comprises a protection circuit, a security circuit and/or a diagnosis circuit for the solar module (2), wherein the electrical circuitry (8) optionally comprises a short-circuit path between the connection devices (10, 11) closeable by an external signal.

12. The apparatus (6) of any of the preceding claims, **characterised in that** the electric circuitry (8) is connected to a signal line (26) leading out of the housing (7).

13. The apparatus (6) of any of the preceding claims, **characterised in that** at least one pull relief device (19, 20) is provided for at least one of the lines (4, 5), and forcing the at least one line (4, 5) in a meander-shape.

14. The apparatus (6) of any of the preceding claims, **characterised in that** for at least one of the lines (4, 5) at least two insulation displacement terminals (9, 27) are provided electrically connecting the electrical circuitry (8) via separate connection devices (10, 11).

15. A solar module (2) comprising two lines (4, 5) carrying a current of the solar module (2) and comprising insulations, the solar module further comprising an apparatus (6) of any of the preceding claims attached to the lines (4, 5).

## Revendications

1. Dispositif (6) comprenant
- un boîtier (7) en plusieurs parties,
- un circuit électrique (8) dans le boîtier (7)
et
- des dispositifs de raccordement (10, 11) pour le raccordement du circuit électrique (8) à deux conduites (4, 5) pourvues d'isolations, conduisant un courant de puissance depuis un module solaire (2),
- de telle sorte qu'au moins un composant du circuit électrique (8) soit monté en parallèle avec le module solaire (2),
- les parties (21, 22) du boîtier (7) pouvant être assemblées autour des conduites (4, 5) s'étendant à travers lui avec leurs isolations et
- les dispositifs de raccordement (10, 11) présentant des éléments de pénétration (9, 27) qui, lors de l'assemblage des parties (21, 22) du boîtier (7), perçant les isolations et viennent en contact électriquement avec les conduites (4, 5),
**caractérisé en ce que**
- pour au moins l'une des conduites (4, 5), une lame de coupe (16) constituée d'un matériau électriquement isolant est prévue, laquelle sectionne la conduite (4, 5) lors de l'assemblage du boîtier (7), des éléments de pénétration (9, 27) étant disposés des deux côtés de la lame de coupe (16).

2. Dispositif (6) selon la revendication 1, **caractérisé en ce que** les parties assemblées (21, 22) du boîtier (7) s'emboîtent les unes avec les autres.

3. Dispositif (6) selon la revendication 1 ou 2, **caractérisé en ce que** le boîtier (7) est en deux parties.

4. Dispositif (6) selon l'une quelconque des revendications précédentes, **caractérisé en ce que** les parties (21, 22) du boîtier (7) sont connectées les unes aux autres par le biais d'une articulation (23) ou une charnière à film.

5. Dispositif (6) selon l'une quelconque des revendications précédentes, **caractérisé en ce que** les éléments de pénétration (9, 27) comprennent des bornes autodénudantes (9) et/ou des aiguilles (27).

6. Dispositif (6) selon l'une quelconque des revendications précédentes, **caractérisé en ce que** les dispositifs de raccordement (10, 11) sont prévus au niveau de côtés opposés du circuit électrique (8).

7. Dispositif (6) selon l'une quelconque des revendications précédentes, **caractérisé en ce que** des joints d'étanchéité (14, 15) réalisent l'étanchéité du boîtier assemblé (7) autour des conduites (4, 5).

8. Dispositif (6) selon l'une quelconque des revendications précédentes, **caractérisé en ce que** des joints d'étanchéité (14, 15) réalisent l'étanchéité des régions (12, 13) du boîtier assemblé (7) comprenant les dispositifs de raccordement (10, 11).

9. Dispositif (6) selon la revendication 7 ou 8, **caractérisé en ce qu'**une masse d'étanchéité réactive pour réaliser les joints d'étanchéité (14, 15) est disposée dans le boîtier (7) dans un réservoir à ouvrir, les parties du boîtier (7) étant en option réalisées de manière à ce que, lors de l'assemblage des parties (21, 22), le réservoir soit ouvert et la masse d'étanchéité soit extraite du réservoir.

10. Dispositif (6) selon l'une quelconque des revendications précédentes, **caractérisé en ce que** le circuit électrique (8) est disposé dans une région étanchéifiée du boîtier assemblé (7).

11. Dispositif (6) selon l'une quelconque des revendications précédentes, **caractérisé en ce que** le circuit électrique (8) présente un circuit de protection, de sécurité et/ou de diagnostic pour le module solaire (2), le circuit électrique (8) présentant en option un chemin de court-circuit pouvant être fermé au moyen d'un signal extérieur entre les dispositifs de raccordement (10, 11).

12. Dispositif (6) selon l'une quelconque des revendications précédentes, **caractérisé en ce que** le circuit électrique (8) est raccordé à une conduite de signal (26) conduisant hors du boîtier (7).

13. Dispositif (6) selon l'une quelconque des revendications précédentes, **caractérisé en ce que** pour au moins l'une des conduites (4, 5) il est prévu au moins un dispositif de décharge de traction (19, 20) qui force la conduite (4, 5) à prendre une forme en méandres.

14. Dispositif (6) selon l'une quelconque des revendications précédentes, **caractérisé en ce que** pour au moins l'une des conduites (4, 5) sont prévus au moins deux éléments de pénétration (9, 27) qui sont connectés au circuit électrique (8) par le biais de dispositifs de raccordement séparés (10, 11).

15. Module solaire (2) comprenant deux conduites (4, 5) présentant des isolations, conduisant un flux de puissance depuis le module solaire (2), et comprenant un dispositif (6) selon l'une quelconque des revendications précédentes, monté sur les conduites (4, 5).
